# EUROPEAN PATENT APPLICATION

(11) **EP 4 451 334 A1**
(43) Date of publication of application: **23.10.2024**
(21) Application number: 22907619.5
(22) Date of filing: 05.09.2022
(51) Int. Cl.: H01L 27/12, H01L 33/62, H01L 33/08, H01L 27/15

(54) **DISPLAY DEVICE COMPRISING SEMICONDUCTOR LIGHT-EMITTING ELEMENT**

(30) Priority: 16.12.2021 KR 20210180547
(71) Applicant: LG Electronics Inc., Yeongdeungpo-gu Seoul 07336 (KR); LG Display Co., Ltd., Seoul 07336 (KR)
(72) Inventor: KIM, Sunho, Seoul 06772 (KR); LEE, Eunhye, Paju-si Gyeonggi-do 10845 (KR); HONG, Gisang, Paju-si Gyeonggi-do 10845 (KR)
(74) Representative: Vossius & Partner Patentanwälte Rechtsanwälte mbB
(86) International application number: PCT/KR2022/013276
(87) International publication number: WO 2023/113148

(57) **Abstract**

The display device according to the embodiment may include a substrate, a first planarization layer containing the first opening on the substrate, a first assembly wiring and a second assembly wiring arranged spaced apart from each other inside the first opening and on the first planarization layer, a second planarization layer covering a portion of the first assembly wiring and the second assembly wiring and including a second opening, a light emitting device disposed inside the second opening, wherein the first electrode overlaps the first assembly wiring and the second assembly wiring, and an insulation layer covering the first assembly wiring or second assembly wiring placed inside the first opening Insulation layer covering the first assembly wiring or second assembly wiring placed inside the first opening, and the first electrode is bonded to one of the first assembly wiring and the second assembly wiring.

## Description

### [Technical field]

The embodiment relates to a display device, and more specifically, to a display device using a semiconductor light emitting device.

### [Background Art]

Display devices used in computer monitors, TVs, mobile phones, etc. include Organic Light Emitting Display (OLED), which emits light on its own, Liquid Crystal Display (LCD), and Micro-LED display, which require a separate light source.

Micro-LED display is a display that uses micro-LED, a semiconductor light emitting device with a diameter or cross-sectional area of 100*µ*m or less, as a display device.

Micro-LED displays use micro-LED, a semiconductor light emitting device, as a display device, so they have excellent performance in many characteristics such as contrast ratio, response speed, color gamut, viewing angle, brightness, resolution, lifespan, luminous efficiency, and luminance.

In particular, the micro-LED display has the advantage of being able to freely adjust the size and resolution and implement a flexible display because the screen may be separated and combined in a modular manner.

However, because large micro-LED displays require more than millions of micro-LEDs, there is a technical problem that makes it difficult to quickly and accurately transfer micro-LEDs to the display panel. Meanwhile, methods for transferring a semiconductor light emitting device to a substrate include a pick and place process, a laser lift-off method, or a self-assembly method.

Among these, the self-assembly method is a method in which a semiconductor light emitting device finds its assembly position within a fluid on its own, and is an advantageous method for implementing a large-screen display device.

Meanwhile, when a light emitting device is transferred in a fluid, there is a problem of the assembly wiring being corroded by the fluid. Corrosion of the assembly wiring may cause an electrical short circuit and cause assembly defects. Additionally, for smooth self-assembly, it is important to secure the contact area between the assembly wiring and the light emitting device.

In addition, the light generated from the assembled light emitting device may be emitted in an unintended direction, resulting in a decrease in light extraction efficiency.

### [Disclosure]

### [Technical Problem]

The technical object of the embodiment is to provide a display device that prevents corrosion of assembly wiring.

Additionally, the technical object of the embodiment is to provide a display device with improved light collection efficiency.

In addition, the technical object of the embodiment is to provide a display device that may use assembly wiring not only for assembling a light emitting device but also as wiring for driving.

Additionally, the technical object of the embodiment is to provide a display device that may prevent color mixing between a plurality of light emitting devices.

In addition, the technical object of the embodiment is to provide a display device that solves the viewing angle problem by varying the direction in which the assembly wiring is spaced apart for each unit pixel.

The objects of the embodiment are not limited to the tasks mentioned above, and other tasks not mentioned will be clearly understood by those skilled in the art from the description below.

### [Technical solution]

A display device having a semiconductor light emitting device according to an embodiment includes a substrate;
A first planarization layer including the first opening on the substrate;
A first assembly wiring and second assembly wiring arranged to be spaced apart from each other inside the first opening and on the first planarization layer;
A second planarization layer covering a portion of the first assembly wiring and the second assembly wiring and including a second opening;
A light emitting device disposed inside the second opening, wherein a first electrode overlaps the first assembly wiring and the second assembly wiring; and
An insulation layer covering the first assembly wiring or the second assembly wiring disposed inside the first opening

The first electrode may be bonded to one of the first assembly wiring and the second assembly wiring.

In addition, in the embodiment, the first assembly wiring includes a first conductive layer and a first clad layer surrounding the first conductive layer,
The second assembly wiring may include a second conductive layer and a second clad layer surrounding the second conductive layer.

The first conductive layer and the second conductive layer may be thicker than the first clad layer and the second clad layer.

The first conductive layer and the second conductive layer may be placed only on the first planarization layer.

It may further include a reflection layer disposed on the first assembly wiring and the second assembly wiring.

The first assembly wiring includes a first portion disposed inside the first opening, a second portion disposed on an inclined surface of the first planarization layer, and a third portion disposed on the upper surface of the second planarization layer,
The second assembly wiring may include a fourth portion disposed inside the first opening, a fifth portion disposed on an inclined surface of the first planarization layer, and a sixth portion disposed on an upper surface of the second planarization layer.

The insulation layer may cover the first portion, the second portion, and the third portion.

The first electrode may be in contact with the second assembly wiring.

The second planarization layer may cover the second portion, the third portion, the fifth portion, and the sixth portion.

The sum of the heights of the first planarization layer and the second planarization layer may be equal to or greater than the height of the light emitting device.

The height of at least one of the first and second clad layers may be equal to or greater than the height of the light emitting device.

It further includes a structure disposed on the first planarization layer, and the first and second conductive layers may be disposed on the structure.

The method of claim 12, wherein the first and second clad layers are in contact with the first and second conductive layers and the structure, respectively, and it may further include a reflection layer disposed on at least one surface of the first and second clad layers.

In addition, a display device including a semiconductor light emitting device according to an embodiment includes a substrate including a plurality of pixels including a plurality of sub-pixels and a unit pixel including the plurality of pixels;
a planarization layer including at least one opening in each of the plurality of sub-pixels;
a plurality of first assembly wirings and a plurality of second assembly wirings arranged to be spaced apart from each other inside the opening and on the planarization layer; and
A plurality of light emitting devices disposed inside the opening, the first electrode of which overlaps the plurality of first assembly wirings and the plurality of second assembly wirings.

The directions in which the plurality of first assembly wirings and the plurality of second assembly wirings included in each of the plurality of pixels within the unit pixel are spaced apart and arranged may be different from each other.

The first electrode may be bonded to one of the first assembly wiring and the second assembly wiring.

It may further include an insulation layer covering any one of the first assembly wiring and the second assembly wiring.

It may further include a reflection layer disposed outside the opening on the first assembly wiring and the second assembly wiring.

The plurality of first assembly wirings and the plurality of second assembly wirings may each be arranged to extend to the plurality of sub-pixels arranged in a column direction.

In the plurality of sub-pixels included in each of the plurality of pixels, the directions in which the plurality of first assembly wirings and the plurality of second assembly wirings are spaced apart and arranged may be the same.

The directions in which the plurality of first assembly wirings and the plurality of second assembly wirings included in each of the plurality of pixels within the unit pixel are spaced apart may have the same angle difference.

### [Advantageous Effects]

According to the embodiment, there is a technical effect of preventing deterioration of the insulating properties of the passivation layer and improving the assembly rate of the light emitting device by arranging the assembly wiring on the same layer.

According to an embodiment, the technical effect of light extraction efficiency of the light emitting device can be improved by arranging the assembly wiring on the inclined surface of the planarization layer including the pocket where the light emitting device will be placed.

In addition, the embodiment has a technical effect in that a plurality of assembly wirings can be used not only for self-assembly of the light emitting device, but also as wiring for driving the light emitting device.

In addition, the embodiment has the technical effect of preventing the viewing angle from being narrowed by varying the arrangement of the assembly wiring for each unit pixel at an isometric angle.

In addition, the embodiment has the technical effect of improving the reliability of the assembly wiring by forming a plurality of assembly wiring structures including a clad layer.

For example, there is a technical effect of reducing corrosion and short circuit defects in multiple assembly wirings by placing only the first clad layer and second clad layer of each assembly wiring at the first opening.

The embodiment has the technical effect of reducing the step between a pluralities of assembly wirings overlapping within an opening provided in the planarization layer, thereby stably bonding a plurality of light emitting devices to the assembly wiring.

The embodiment has the technical effect of preventing color mixing and crosstalk phenomenon from mixing with light from other light emitting devices because the light generated from the light emitting device 130 is not emitted in an unintended direction.

The effects according to the embodiment are not limited by the contents exemplified above, and a wider variety of effects are included within the present invention.

### [Description of Drawings]

FIG. 1 is a schematic plan view of a display device according to an embodiment.
FIG. 2 is a schematic enlarged plan view of a display device according to an embodiment.
FIG. 3 is a cross-sectional view taken along line III-III' of FIG. 2.
FIG. 4 is a cross-sectional view of a modified example of FIG. 3.
FIG. 5 is a cross-sectional view of a display device according to the second embodiment.
FIG. 6 is a cross-sectional view of a modified example of FIG. 5.
FIGS. 7A to 7C are process diagrams for explaining a method of manufacturing a display device according to an embodiment.
FIG. 8 is a plan view showing assembly wiring arranged isometrically in unit pixels included in a display device according to an embodiment.

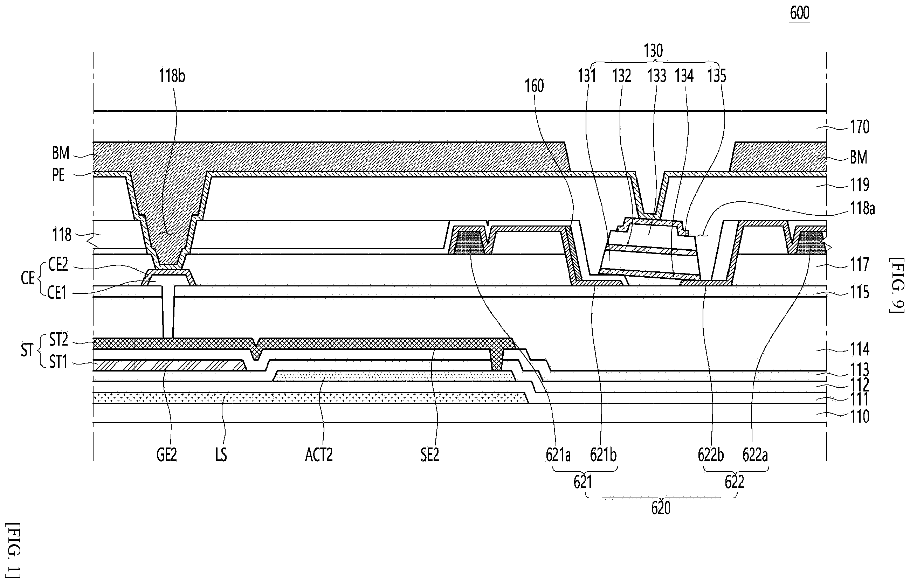

FIG. 9 is a cross-sectional view of a display device according to the fourth embodiment.
FIG. 10 is a cross-sectional view of a display device according to the fifth embodiment.

### [Mode for Invention]

Hereinafter, embodiments disclosed in this specification will be described in detail with reference to the attached drawings. The suffixes 'module' and 'part' for components used in the following description are given or used interchangeably in consideration of ease of specification preparation, and do not have distinct meanings or roles in themselves. In addition, the attached drawings are intended to facilitate easy understanding of the embodiments disclosed in this specification, and the technical ideas disclosed in this specification are not limited by the attached drawings. Additionally, when an element such as a layer, region or substrate is referred to as being 'on' another component, this includes either directly on the other element or there may be other intermediate elements in between.

Display devices described in this specification include digital TVs, mobile phones, smart phones, laptop computers, digital broadcasting terminals, personal digital assistants (PDAs), portable multimedia players (PMPs), navigation, slate PCs, tablet PCs, ultra-books, desktop computers, etc. However, the configuration according to the embodiment described in this specification may be applied to a device capable of displaying, even if it is a new product type that is developed in the future.

Hereinafter, an embodiment will be described with reference to the drawings.

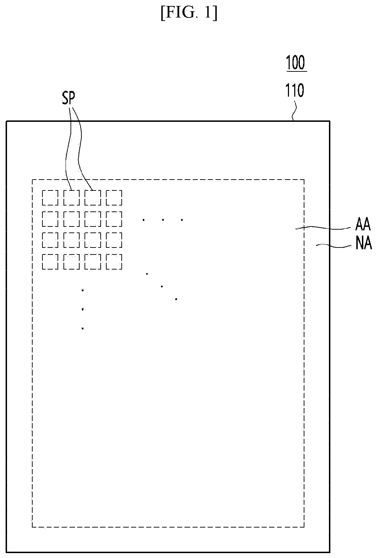

FIG. 1 is a schematic plan view of a display device according to the embodiment. In FIG. 1, for convenience of explanation, only the substrate 110 and a plurality of sub pixels SP are shown among the various components of the display device 100.

The display device 100 according to the embodiment may include a flexible display manufactured on a thin and flexible substrate. Flexible displays may bend or curl like paper while maintaining the characteristics of existing flat displays.

In a flexible display, visual information may be implemented by independently controlling the light emission of unit pixels arranged in a matrix form. A unit pixel refers to the minimum unit for implementing one color. A unit pixel of a flexible display may be implemented by a light-emitting device. In the embodiment, the light emitting device may be Micro-LED or Nano-LED, but is not limited thereto.

The substrate 110 is configured to support various components included in the display device 100, and may be made of an insulating material. For example, the substrate 110 may be made of glass or resin. Additionally, the substrate 110 may include polymer or plastic, or may be made of a material with flexibility.

The substrate 110 includes a display area AA and a non-display area NA.

The display area AA is an area where a plurality of sub pixels SP are arranged and an image is displayed. Each of the plurality of sub pixels SP is an individual unit that emits light, and a light emitting device LED and a driving circuit are formed in each of the plurality of sub pixels SP. For example, the plurality of sub pixels SP may include a red sub pixel, a green sub pixel, a blue sub pixel, and/or a white sub pixel, but are not limited thereto. Hereinafter, the description will be made assuming that the plurality of sub pixels SP includes a red sub pixel, a green sub pixel, and a blue sub pixel, but is not limited thereto.

The non-display area NA is an area where images are not displayed, and is an area where various wiring, driver ICs, etc. are placed to drive the sub pixels SP arranged in the display area AA. For example, various ICs, such as gate driver ICs and data driver ICs, and driving circuits may be placed in the non-display area NA. Meanwhile, the non-display area NA may be located on the back of the substrate 110, that is, on the side without sub pixels SP, or may be omitted, and is not limited to what is shown in the drawing.

The display device 100 of the embodiment may drive the light emitting device in an active matrix (AM, Active Matrix) method or a passive matrix (PM, Passive Matrix) method.

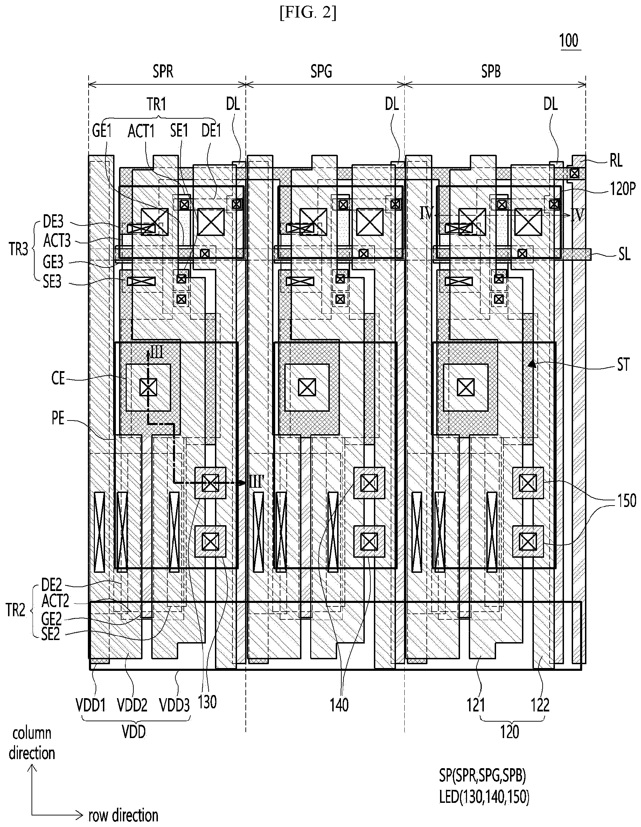

Hereinafter, FIGS. 2 to 4 will be referred to for a more detailed description of the plurality of sub pixels SP.

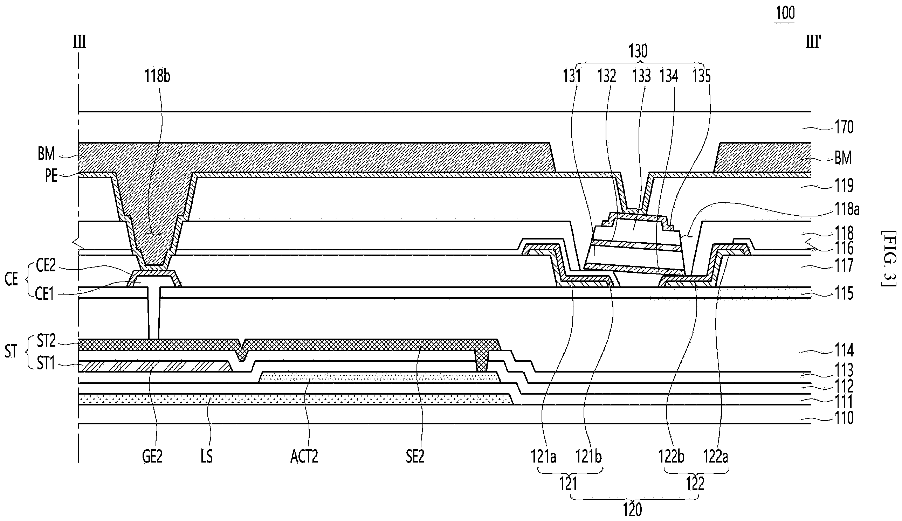

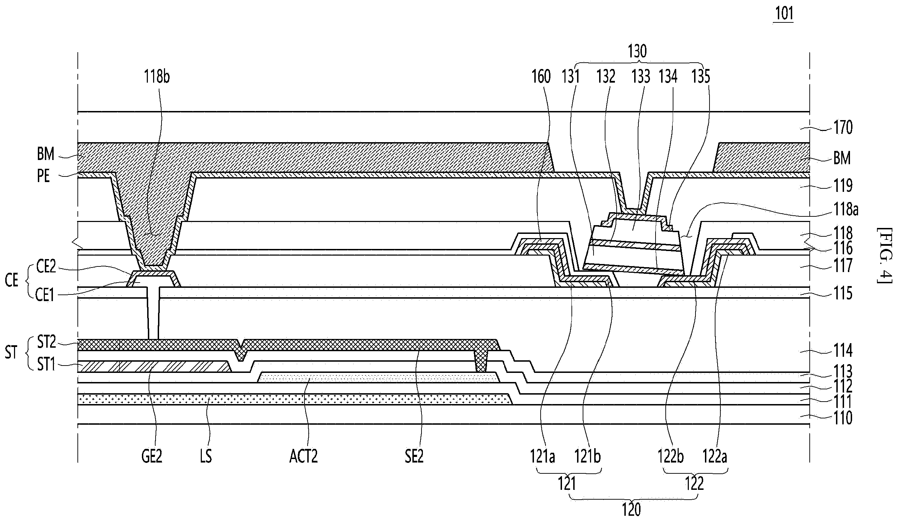

FIG. 2 is a schematic enlarged plan view of a display device according to an embodiment. FIG. 3 is an enlarged plan view of area A of FIG. 2. FIG. 4 is a cross-sectional view taken along line IV-IV' of FIG. 2. Referring to FIGS. 2 to 4, the display device 100 according to an embodiment may include a plurality of scan lines SL, a plurality of data lines DL, a plurality of high potential power supply wirings VDD, a plurality of assembly wiring 120, a plurality of reference lines RL and a plurality of reference line RL and a black matrix BM, a first transistor TR1, a second transistor TR2, a third transistor TR3 for each of the plurality of sub pixels SP, a storage capacitor ST, a semiconductor light emitting device LED, a light blocking layer LS, a buffer layer 111, a gate insulating layer 112, a plurality of passivation layers 113, 115 and 116, a plurality of planarization layers 114, 117 and 118, connection electrodes 123, and pixel electrodes PE, etc.

Referring to FIGS. 2 and 4, a plurality of data lines DL, a first layer VDD1 and a second layer VDD2 of high potential power supply wiring VDD, a plurality of reference lines RL and a plurality of assembly wirings 120 extend in a column direction between a plurality of sub pixels SP, and a third layer VDD3 of the plurality of scan lines SL and the high potential power supply wiring VDD may extend in the row direction between the plurality of sub pixels SP. Additionally, a first transistor TR1, a second transistor TR2, a third transistor TR3, and a storage capacitor ST may be disposed in each of the plurality of sub pixels SP.

First, the first layer VDD1 of the high potential power supply wiring VDD and the light blocking layer LS may be disposed on the substrate 110.

The high potential power supply wiring VDD is a wiring that transmits a high potential power supply voltage to each of a plurality of sub pixels SP. The plurality of high potential power supply wirings VDD may transmit a high potential power supply voltage to the second transistor TR2 of each of the plurality of sub pixels SP.

Meanwhile, a plurality of high potential power wiring VDD may be made of a single layer or multiple layers, hereinafter, for convenience of explanation, the description will be made on the assumption that a plurality of high potential power supply wirings VDDs are composed of a plurality of layers.

The high potential power supply wiring VDD includes a plurality of first layers VDD1, a plurality of second layers VDD2, and a plurality of third layers VDD3 connecting them. The first layer VDD1 may extend in the column direction between each of the plurality of sub pixels SP.

A light blocking layer LS may be disposed in each of a plurality of sub pixels SP on the substrate 110. The light blocking layer LS may minimize leakage current by blocking light incident from the lower portion of the substrate 110 to the second active layer ACT2 of the second transistor TR2, which will be described later

The buffer layer 111 may be disposed on the first layer VDD1 and the light blocking layer (LS) of the high-potential power line VDD. The buffer layer 111 may reduce the penetration of moisture or impurities through the substrate 110. The buffer layer 111 may be composed of, for example, a single layer or a multiple layer of silicon oxide (SiOx) or silicon nitride (SiNx), but is not limited thereto. However, the buffer layer 111 may be omitted depending on the type of substrate 110 or the type of transistor, but is not limited thereto.

A plurality of a scan lines SL, a plurality of a reference lines RL, a plurality of a data lines DL, a first transistor TR1, a second transistor TR2, a third transistor TR3, and a storage capacitor ST may be disposed on a buffer layer 111.

First, the first transistor TR1 may be disposed in each of the plurality of sub-pixels SP. The first transistor TR1 includes a first active layer ACT1, a first gate electrode GE1, a first source electrode SE1, and a first drain electrode DE1. The first active layer ACT1 may be disposed on the buffer layer 111. The first active layer ACT1 may be made of a semiconductor material such as oxide semiconductor, amorphous silicon, or polysilicon, but is not limited thereto.

The gate insulating layer 112 may be disposed on the first active layer ACT1. The gate insulating layer 112 is an insulating layer for insulating the first active layer ACT and the first gate electrode GE1, and may be composed of a single layer or multiple layers of silicon oxide (SiOx) or silicon nitride (SiNx), but it is not limited to this.

The first gate electrode GE1 may be disposed on the gate insulating layer 112. The first gate electrode GE1 may be electrically connected to the scan line SL. The first gate electrode GE1 may be made of a conductive material, such as, copper (Cu), aluminum (Al), molybdenum (Mo), nickel (Ni), titanium (Ti), chromium (Cr), or an alloy thereof, but is not limited thereto.

The first passivation layer 113 may be disposed on the first gate electrode GE1. Contact holes are formed in the first passivation layer 113 to connect the first source electrode SE1 and the first drain electrode DE1 to the first active layer ACT. The first passivation layer 113 is an insulating layer to protect the structure below the first passivation layer 113, and may be composed of a single layer or multiple layers of silicon oxide (SiOx) or silicon nitride (SiNx), but is limited thereto.

A first source electrode SE1 and a first drain electrode DE1 electrically connected to the first active layer ACT may be disposed on the first passivation layer 113. The first drain electrode DE1 may be connected to the data line DL, and the first source electrode SE1 may be connected to the second gate electrode GE2 of the second transistor TR2. The first source electrode SE1 and the first drain electrode DE1 may be made of a conductive material, such as, copper (Cu), aluminum (Al), molybdenum (Mo), nickel (Ni), titanium (Ti), chromium (Cr), or an alloy thereof, but is not limited thereto.

Meanwhile, in the embodiment, it has been described that each of the first source electrode SE1 and the first drain electrode DE1 is connected to the second gate electrode GE2 and the data line DL. However, depending on the type of transistor, the first source electrode SE1 may be connected to the data line DL, and the first drain electrode DE1 may be connected to the second gate electrode GE2 of the second transistor TR2, but are not limited thereto.

The first gate electrode GE1 of the first transistor TR1 is connected to the scan line SL and may be turned on or off depending on the scan signal. The first transistor TR1 may transmit a data voltage to the second gate electrode GE2 of the second transistor TR2 based on the scan signal, and may be referred to as a switching transistor.

Meanwhile, a plurality of data lines DL and a plurality of reference lines RL may be disposed on the gate insulating layer 112 along with the first gate electrode GE1. The plurality of data lines DL and the reference lines RL may be formed of the same material and process as the first gate electrode GE1.

The plurality of data lines DL are wires that transmit data voltage to each of the plurality of sub pixels SP. The plurality of data lines DL may transmit data voltage to the first transistor TR1 of each of the plurality of sub pixels SP. For example, the plurality of data lines DL may be made of a data line DL that transmits data voltage to the red sub pixel SPR, a data line DL that transmits data voltage to the green sub pixel SPG and a data line DL that transmits data voltage to the blue sub pixel SPB.

A plurality of reference lines RL are wires that transmit a reference voltage to each of a plurality of sub pixels SP. The plurality of reference lines RL may transmit the reference voltage to the third transistor TR3 of each of the plurality of sub pixels SP.

The second transistor TR2 may be disposed in each of the plurality of sub-pixels SP. The second transistor TR2 includes a second active layer ACT2, a second gate electrode GE2, a second source electrode SE2, and a second drain electrode DE2. The second active layer ACT2 may be disposed on the buffer layer 111. The second active layer ACT2 may be made of a semiconductor material such as oxide semiconductor, amorphous silicon, or polysilicon, but is not limited thereto.

The gate insulating layer 112 may be disposed on the second active layer ACT2, and the second gate electrode GE2 may be disposed on the gate insulating layer 112. The second gate electrode GE2 may be electrically connected to the first source electrode SE1 of the first transistor TR1. The second gate electrode GE2 may be made of a conductive material, such as copper (Cu), aluminum (Al), molybdenum (Mo), nickel (Ni), titanium (Ti), chromium (Cr), or an alloy thereof, but is not limited thereto.

The first passivation layer 113 may be disposed on the second gate electrode GE2, and the second source electrode SE2 and the second drain electrode DE2 may be disposed on the first passivation layer 113. The second source electrode SE2 is electrically connected to the second active layer ACT2. The second drain electrode DE2 may be electrically connected to the second active layer ACT2 and at the same time is electrically connected to the high potential power supply wiring VDD. The second drain electrode DE2 may be disposed between the first layer VDD1 and the second layer VDD2 of the high potential power supply wiring VDD and electrically connected to the high potential power supply wiring VDD.

Since the second gate electrode GE2 of the second transistor TR2 is connected to the first source electrode SE1 of the first transistor TR1, when the first transistor TR1 is turned on, it may be turned on by the data voltage transmitted. And the turned on second transistor TR2 may transfer the driving current to the light emitting device LED based on the high potential power supply voltage from the high potential power supply wiring VDD, so it may be referred to as a driving transistor.

The third transistor TR3 may be disposed in each of the plurality of sub pixels SP. The third transistor TR3 may include a third active layer ACT3, a third gate electrode GE3, a third source electrode SE3, and a third drain electrode DE3. The third active layer ACT3 may be disposed on the buffer layer 111. The third active layer ACT3 may be made of a semiconductor material such as oxide semiconductor, amorphous silicon, or polysilicon, but is not limited thereto.

The gate insulating layer 112 may be disposed on the third active layer ACT3, and the third gate electrode GE3 may be disposed on the gate insulating layer 112. The third gate electrode GE3 is connected to the scan line SL, and the third transistor TR3 may be turned on or off by the scan signal. The third gate electrode GE3 may be made of a conductive material, such as copper (Cu), aluminum (Al), molybdenum (Mo), nickel (Ni), titanium (Ti), chromium (Cr), or an alloy thereof, but is not limited thereto.

However, in the above description, the third gate electrode GE3 and the first gate electrode GE1 are connected to the same scan line SL, the third gate electrode GE3 may be connected to a different scan line SL from the first gate electrode GE1, but is not limited thereto.

The first passivation layer 113 may be disposed on the third gate electrode GE3, and the third source electrode SE3 and the third drain electrode DE3 may be disposed on the first passivation layer 113. The third source electrode SE3 is formed integrally with the second source electrode SE2, and may be electrically connected to the third active layer ACT3 and simultaneously to the second source electrode SE2 of the second transistor TR2. And the third drain electrode DE3 may be electrically connected to the reference line RL.

The third transistor TR3 electrically connected to the second source electrode SE2, reference line RL, and storage capacitor ST of the second transistor TR2, which is a driving transistor, may be referred to as a sensing transistor.

A storage capacitor ST may be disposed in each of a plurality of sub pixels SP. The storage capacitor ST may include a first capacitor electrode ST1 and a second capacitor electrode ST2. The storage capacitor ST is connected between the second gate electrode GE2 and the second source electrode SE2 of the second transistor TR2, by storing the voltage, the voltage level of the gate electrode of the second transistor TR2 may be maintained constant while the light emitting device LED emits light.

The first capacitor electrode ST1 may be integrated with the second gate electrode GE2 of the second transistor TR2. Accordingly, the first capacitor electrode ST1 may be electrically connected to the second gate electrode GE2 of the second transistor TR2 and the first source electrode SE1 of the first transistor TR1.

The second capacitor electrode ST2 is disposed on the first capacitor electrode ST1 with the first passivation layer 113 interposed therebetween. The second capacitor electrode ST2 may be integrated with the second source electrode SE2 of the second transistor TR2 and the third source electrode SE3 of the third transistor TR3. Accordingly, the second capacitor electrode ST2 may be electrically connected to the second transistor TR2 and the third transistor TR3.

Meanwhile, the plurality of scan lines SL may be disposed on a first passivation layer 113 with a first source electrode SE1, a first drain electrode DE1, a second source electrode SE2, a second drain electrode DE2, a third source electrode SE3, a third drain electrode DE3 and a second capacitor electrode ST2.

The plurality of scan lines SL are wires that transmit scan signals to each of the plurality of sub pixels SP. The plurality of scan lines SL may transmit scan signals to the first transistor TR1 of each of the plurality of sub pixels SP. For example, each of the plurality of scan lines SL extends in the row direction and may transmit a scan signal to a plurality of sub pixels SP arranged in the same row.

Next, the first planarization layer 114 may disposed on a plurality of scan lines SL, a plurality of reference lines RL, a plurality of data lines DL, a first transistor TR1, a second transistor TR2, a third transistor TR3 and storage capacitor ST. The first planarization layer 114 may planarize the upper portion of the substrate 110 on which a plurality of transistors are disposed. The first planarization layer 114 may be composed of a single layer or a double layer, and may be made of, for example, an acryl-based organic material, but is not limited thereto.

The second passivation layer 115 may be disposed on the first planarization layer 114. The second passivation layer 115 is an insulating layer for protecting the structure below the second passivation layer 115 and improving the adhesion of the structure formed on the second passivation layer 115, so the second passivation layer 115 may be composed of a single layer or multiple layers of silicon oxide (SiOx) or silicon nitride (SiNx), but is not limited thereto.

A second layer VDD2 of the high-potential power wiring VDD, a plurality of assembly wirings 120, and a connection electrode CE may be disposed on the second passivation layer 115.

The connection electrode CE disposed in each sub-pixel SP is electrically connected to the second capacitor electrode ST2 and the second source electrode SE2 of the second transistor TR2 through the contact hole formed in the first planarization layer 114 and the second passivation layer 115. The connection electrode CE is an electrode for electrically connecting a light emitting device LED and the second transistor TR2, which is a driving transistor, and includes a first connection layer CE1 and a second connection layer CE2. For example, the first connection layer CE1 may be made of a conductive material, such as copper (Cu) and chromium (Cr), but is not limited thereto. Additionally, the second connection layer CE2 may be made of molybdenum (Mo), molybdenum titanium (MoTi), etc., but is not limited thereto.

The second layer VDD2 of the high-potential power line VDD may be disposed on the second passivation layer 115. The second layer VDD2 extends in the column direction between each of the plurality of sub-pixels SP and may overlap the first layer VDD1. The first layer VDD1 and the second layer VDD2 may be electrically connected through a contact hole formed in the insulation layers formed between the first layer VDD1 and the second layer VDD2. The second layer VDD2 may be formed of the same material and process as the connection electrode CE, but is not limited thereto.

Next, a second planarization layer 117 is disposed on the second layer VDD2 and the connection electrode CE. The second planarization layer 117 may be composed of a single layer or a double layer, and may be made of, for example, an acryl-based organic material, but is not limited thereto.

Meanwhile, the second planarization layer 117 includes a plurality of first openings where assembly wiring 120 is arranged and each of a plurality of light emitting devices LED is seated.

A plurality of first openings may be arranged in each of a plurality of sub-pixels SP. At this time, more than one first opening may be arranged in one sub-pixel SP. For example, one first opening may be placed in one sub-pixel SP, or two first openings may be placed in one sub-pixel SP. Additionally, assembly wiring 120 may be arranged within the plurality of first openings. Specifically, the assembly wiring 120 may be disposed on the side (slope surface) and top surface of the second planarization layer 117 and the top surface of the second passivation layer 115.

A plurality of assembly wiring 120 generates an electric field to align a plurality of light emitting devices LED when manufacturing the display device 100, and this is a wiring that supplies low-potential power voltage to a plurality of light emitting devices LED when the display device 100 is driven. Accordingly, the assembly wiring 120 may be referred to as low-potential power wiring. The plurality of assembly wirings 120 may be arranged in a column direction along the plurality of sub-pixels SP arranged on the same line. A plurality of assembly wirings 120 may be arranged to overlap a plurality of sub-pixels SP arranged in the same column. For example, a first assembly wiring 121 and a second assembly wiring 122 are arranged in a red sub-pixel SPR arranged in the same row, one first assembly wiring 121 and one second assembly wiring 122 are arranged in the green sub-pixel SPG, one first assembly wiring 121 and a second assembly wiring 122 may be disposed in the blue sub-pixel SPB.

The plurality of assembly wirings 120 may include a plurality of first assembly wirings 121 and a plurality of second assembly wirings 122. When the display device 100 is driven, the same low-potential voltage may be applied as alternating current to the plurality of first assembly wirings 121 and the plurality of second assembly wirings 122. The plurality of first assembly wirings 121 and the plurality of second assembly wirings 122 may be alternately arranged. And, in each of the plurality of sub-pixels SP, one first assembly wiring 121 and one second assembly wiring 122 may be arranged adjacent to each other.

The plurality of first assembly wirings 121 and the plurality of second assembly wirings 122 may be made of a conductive material, such as copper (Cu) and chromium (Cr), but it is not limited to this.

The plurality of first assembly wirings 121 include a first conductive layer 121a and a first clad layer 121b. The first conductive layer 121a may be disposed on the top and side surfaces (slope surfaces) of the second planarization layer 117 and the second passivation layer 115 within the first opening of the second planarization layer 117. The first clad layer 121b may be in contact with the first conductive layer 121a. For example, the first clad layer 121b may be arranged to cover the top and side surfaces of the first conductive layer 121a. And the first conductive layer 121a may have a thicker thickness than the first clad layer 121b.

Since the first clad layer 121b is made of a material that is more resistant to corrosion than the first conductive layer 121a, when manufacturing a display device 100, short circuit defects due to migration between the first conductive layer 121a of the first assembly wiring 121 and the second conductive layer 122a of the second assembly wiring 122 may be minimized. For example, the first clad layer 121b may be made of molybdenum (Mo), molybdenum titanium (MoTi), etc., but is not limited thereto.

Like the plurality of first assembly wirings 121, the plurality of second assembly wirings 122 may also be arranged at the first opening of the second planarization layer 117. Each of the plurality of second assembly wirings 122 is disposed in a plurality of sub-pixels SP arranged on the same line as described above, and the plurality of first assembly wirings 121 and the plurality of second assembly wirings 122 may be arranged to be spaced apart from each other.

Each of the plurality of second assembly wirings 122 includes a second conductive layer 122a and a second clad layer 122b. The second conductive layer 122a may be disposed on the top and side surfaces (slope surfaces) of the second planarization layer 117 and the second passivation layer 115 within the opening of the second planarization layer 117. And the second clad layer 122b may be electrically connected to the second conductive layer 122a. For example, the second clad layer 122b may be arranged to cover the top and side surfaces of the second conductive layer 122a. And the second conductive layer 122a may have a thicker thickness than the second clad layer 122b.

Since the second clad layer 122b, like the first clad layer 121b, is also made of a material that is more resistant to corrosion than the second conductive layer 122a, there is a technical effect of minimizing short circuit defects due to migration between the first assembly wiring 121 and the second assembly wiring 122 when manufacturing the display device 100. For example, the second clad layer 122b may be made of molybdenum (Mo), molybdenum titanium (MoTi), etc., but is not limited thereto.

In the display device 100 according to the embodiment, the light extraction efficiency of the light emitting device 130 may be improved by arranging the first assembly wiring 121 and the second assembly wiring 122 to cover the inclined surface of the second planarization layer 117 within the first opening.

Subsequently, the third passivation layer 116 may be disposed on the assembly wiring 120 and the second planarization layer 117. The third passivation layer 116 is an insulation layer to prevent short circuit between the first assembly wiring 121 and the second assembly wiring 122, so it may cover both the top and sides of the first assembly wiring 121, and only part or not all of the second assembly wiring 122. Or the opposite case is also possible. The third passivation layer 116 may be composed of a single layer or a multiple layer of silicon oxide (SiOx) or silicon nitride (SiNx), but is not limited thereto.

In particular, since the first assembly wiring 121 and the second assembly wiring 122 are formed on the same layer through the same process, the insulating properties of the third passivation layer 116 may be maintained, so the assembly rate of the light emitting device 130 may be improved. Additionally, the third passivation layer 116 may be a hydrogen-free film that does not generate hydrogen during formation of the third passivation layer 116. The hydrogen-free film may be formed thinner than other films that generate hydrogen during the process, so it does not weaken the electric field in the assembly wiring and does not cause deterioration of the transistor.

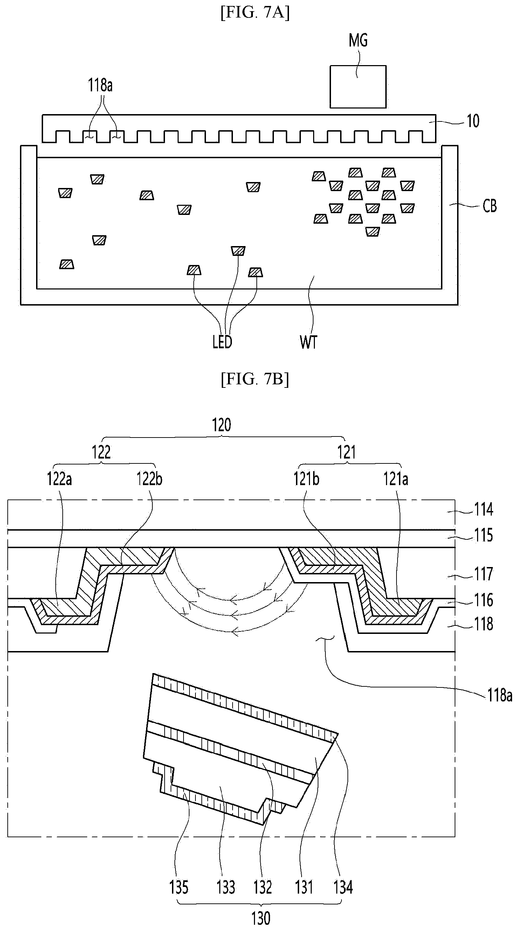

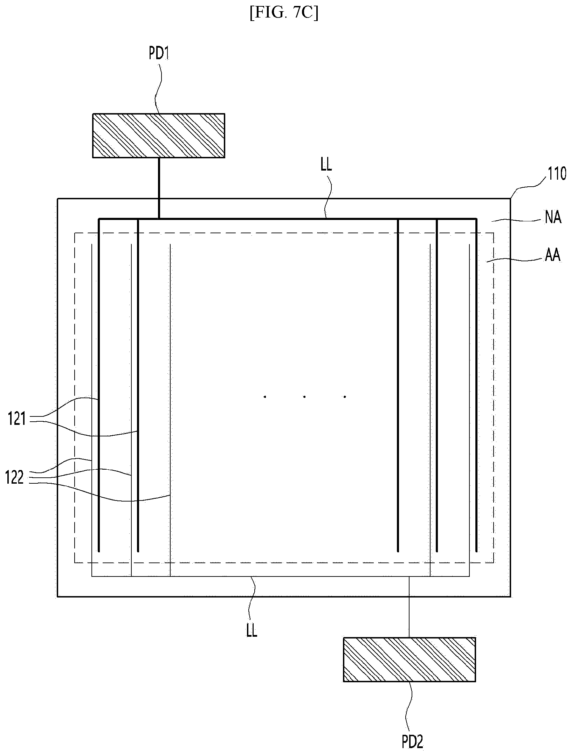

The hydrogen-free film may be, for example, silicon oxide (SiOx). In addition, the third passivation layer 116 may function as an insulation layer to prevent short circuit defects due to migration between the first assembly wiring 121 and the second assembly wiring 122 when manufacturing the display device 100.. This will be described later with reference to FIGS. 7A and 7C.

Next, the third planarization layer 118 may be disposed on the plurality of first assembly wirings 121 and the plurality of second assembly wirings 122. The third planarization layer 118 may be composed of a single layer or a double layer, and may be made of, for example, an acryl-based organic material, but is not limited thereto.

The third planarization layer 118 includes a plurality of second openings 118a where each of a plurality of light emitting devices LED is seated. The plurality of second openings 118a are parts where a plurality of light emitting devices LED are inserted, and may also be referred to as pockets. In order for a plurality of light emitting devices LED to be inserted and stably seated in the plurality of second openings 118a, the sum of the heights of the second planarization layer 117 and the third planarization layer 118 is equal to or greater than the height of the light emitting device LED.

The plurality of second openings 118a may be formed to overlap the plurality of assembly wirings 120. For example, one second opening 118a may overlap the first assembly wiring 121 and the second assembly wiring 122 arranged adjacent to each other in one sub-pixel SP.

A plurality of second openings 118a overlap with a plurality of first openings, and the size of the second opening 118a may be smaller than the size of the first opening.

Meanwhile, if the first assembly wiring 121 and the second assembly wiring 122 are divided into three parts, the first portion of the first assembly wiring 121 is disposed on the second passivation layer 115 inside the first opening, the second portion of the first assembly wiring 121 is disposed on the inclined surface (side) of the second planarization layer 117, the third portion of the first assembly wiring 121 may be disposed on the upper surface of the third planarization layer 117.

The second assembly wiring 122 is the same as the first assembly wiring 121, the first portion of the second assembly wiring 122 is disposed on the second passivation layer 115 inside the first opening, the second portion of the second assembly wiring 122 is disposed on the inclined surface (side) of the second planarization layer 117, and the third portion of the second assembly wiring 122 may be disposed on the upper surface of the third planarization layer 117. In this case, the third planarization layer 118 may cover all of the second portion and third portion and part of the first portion of the first assembly wiring 121, and may cover all of the second and third portions of the second assembly wiring 122, and part of the first portion.

Also, portions of the plurality of first assembly wirings 121 and the plurality of second assembly wirings 122 may be exposed at the second opening 118a. On the other hand, in the second opening 118a, the third passivation layer 116 covers all of the first assembly wiring 121, so the first assembly wiring 121 overlaps the second opening 118a, but it is not exposed in the second opening 118a.

Next, a plurality of third openings 118b are disposed in the plurality of sub-pixels SP. The plurality of third openings 118b are portions that expose the connection electrodes CE of each of the plurality of sub-pixels SP. The connection electrode CE below the second planarization layer 117 is exposed at the plurality of third openings 118b and may be electrically connected to a light emitting device LED, and the driving current from the second transistor TR2 may be transferred to a light emitting device LED. In this case, the third passivation layer 116 may have a contact hole in the area overlapping the third opening 118b, and the connection electrode CE may be exposed from the second planarization layer 117 and the third passivation layer 116.

A plurality of light emitting devices LED are disposed in the plurality of second openings 118a. A plurality of light emitting devices LED are light emitting devices LED that emit light by electric current. The plurality of light emitting devices LED may include light emitting devices LED that emit red light, green light, blue light, etc., and the combination of these may produce light of various colors, including white. For example, the light emitting device LED may be, but is not limited to, a Light Emitting Diode LED or micro LED. In this case, micro LED may mean that the size of the light emitting device is 100µm or less.

Hereinafter, the description will be made assuming that a plurality of light emitting devices LED include a red light emitting device 130 disposed in the red sub-pixel SPR, a green light emitting device 140 disposed in a green sub-pixel SPG, a blue light emitting device 150 placed in the blue sub-pixel SPB. However, the plurality of light emitting devices LED are composed of light emitting devices LED that emit light of the same color, and images of various colors may be displayed using a separate light conversion member that converts light from a plurality of light emitting devices LED into light of different colors, but is not limited thereto.

A plurality of light emitting devices LED may include a red light emitting device 130 disposed in the red sub-pixel SPR, a green light emitting device 140 placed in green sub-pixel SPG and a blue light emitting device 150 placed in the blue sub-pixel SPB. Each of the red light emitting device 130, the green light emitting device 140, and the blue light emitting device 150 may include a first semiconductor layer, a second semiconductor layer, a first electrode, and a second electrode in common. And the red light emitting device 130 includes a light emitting layer that emits red light, the green light emitting device 140 includes a light emitting layer that emits green light, and the blue light emitting device 150 may include a light emitting layer that emits blue light.

Referring to FIG. 3, the red light emitting device 130 disposed in the red sub-pixel SPR has a second semiconductor layer 133 disposed on the first semiconductor layer 131. The first semiconductor layer 131 and the second semiconductor layer 133 may be layers formed by doping n-type and p-type impurities into a specific material. For example, the first semiconductor layer 131 and the second semiconductor layer 133 may include an AlInGaP-based semiconductor layer, for example, it may be a layer doped with a p-type or n-type impurity in a material such as indium aluminum phosphide (InAlP) or gallium arsenide (GaAs). And the p-type impurities may be magnesium MG, zinc (Zn), beryllium (Be), etc., and the n-type impurities may be silicon (Si), germanium (Ge), tin (Sn), etc., but are not limited thereto.

A light emitting layer 132 that emits red light may be disposed between the first semiconductor layer 131 and the second semiconductor layer 133. The light emitting layer 132 may emit light by receiving holes and electrons from the first semiconductor layer 131 and the second semiconductor layer 133. The light-emitting layer 132 may have a single-layer or multi-quantum well (MQW) structure, and may be made of, for example, indium gallium nitride (InGaN) or gallium nitride (GaN), but it is not limited thereto.

The first electrode 134 may be placed on the bottom of the first semiconductor layer 131, and the second electrode 135 may be placed on the top of the second semiconductor layer 133. The first electrode 134 is an electrode bonded to the second assembly wiring 122 exposed at the second opening 118a, and the second electrode 135 is an electrode that electrically connects the pixel electrode PE, which will be described later, with the second semiconductor layer 133. The first electrode 134 and the second electrode 135 may be formed of a conductive material.

In this case, in order to bond the first electrode 134 to the second assembly wiring 122, the first electrode 134 may be made of a eutectic metal. For example, the first electrode 134 may be made of tin (Sn), indium (In), zinc (Zn), lead (Pb), nickel (Ni), gold (Au), platinum (Pt), copper (Cu), etc., but is not limited thereto.

And both the green light emitting device 140 and the blue light emitting device 150 may be formed in the same or similar structure as the red light emitting device 130. For example, the green light emitting device 140 may include a first electrode, a first semiconductor layer on the first electrode, a green emitting layer on the first semiconductor layer, a second semiconductor layer on the green emitting layer, a second electrode on second semiconductor layer, and a blue light emitting device may also include a structure in which a first electrode, a first semiconductor layer, a blue light emitting layer, a second semiconductor layer, and a second electrode are sequentially stacked.

However, the green light emitting device 140 and the blue light emitting device 150 may be formed of a compound selected from the group consisting of GaN, AlGaN, InGaN, AlInGaN, GaP, AlN, GaAs, AlGaAs, InP, and mixtures thereof, but is not limited thereto.

Meanwhile, although not shown in the drawing, an insulation layer surrounding a portion of each of the plurality of light emitting devices LED may be disposed. Specifically, the insulation layer may cover at least the side of the light emitting device LED among the outer surfaces of the plurality of light emitting devices LED. By forming an insulation layer on the light emitting device LED, it protects the light emitting device LED, so that when forming first electrode 134 and second electrode 135, electrical short circuit between the first semiconductor layer 131 and the second semiconductor layer 133 may be prevented.

Next, the fourth planarization layer 119 may be disposed on a plurality of light emitting devices LED. The fourth planarization layer 119 may planarize the upper part of the substrate 110 on which a plurality of light emitting devices LED are arranged, and the plurality of light emitting devices LED may be stably fixed in the second opening 118a by the fourth planarization layer 119. The fourth planarization layer 119 may be composed of a single layer or a double layer, and may be made of, for example, an acryl-based organic material, but is not limited thereto.

The pixel electrode PE may be disposed on the fourth planarization layer 119. The pixel electrode PE is an electrode for electrically connecting a plurality of light emitting devices LED and the connection electrode CE. The pixel electrode PE may be electrically connected to the light emitting device LED of the second opening 118a and the connection electrode CE of the third opening 118b through a contact hole formed in the fourth planarization layer 119.. Accordingly, the second electrode 135 of the light emitting device LED, the connection electrode CE, and the second transistor TR2 may be electrically connected through the pixel electrode PE.

The third layer VDD3 of the high-potential power line VDD may be disposed on the fourth planarization layer 119. The third layer VDD3 may electrically connect the first layer VDD1 and the second layer VDD2 arranged in different rows. For example, the third layer VDD3 extends in the row direction between the plurality of sub-pixels SP, and a plurality of second layers VDD2 of the high potential power supply line VDD extending in the column direction may be electrically connected to each other. In addition, as the plurality of high-potential power wiring lines VDD are connected in a mesh form through the third layer VDD3, the voltage drop phenomenon may be reduced.

A black matrix BM may be disposed on the fourth planarization layer 119. The black matrix BM may be disposed between the pluralities of sub-pixels SP on the fourth planarization layer 119. The black matrix BM may prevent color mixing between the pluralities of sub-pixels SP. The black matrix BM may be made of an opaque material, for example, black resin, but is not limited thereto.

A protective layer 170 is disposed on the pixel electrode PE, the fourth planarization layer 119, and the black matrix BM. The protective layer 170 is a layer to protect the structure below the protective layer 170, and may be composed of a single layer or multiple layers of translucent epoxy, silicon oxide (SiOx), or silicon nitride (SiNx), but is not limited thereto.

Meanwhile, in the second opening 118a, the plurality of first assembly wirings 121 are spaced apart from the plurality of light emitting devices LED, and only the plurality of second assembly wirings 122 may contact the plurality of light emitting devices LED. A third passivation layer 116 may be formed on the plurality of first assembly wirings 121, and a plurality of light emitting devices LED may be contacted only to the plurality of second assembly wirings 122. And this is to prevent defects that occur when a plurality of light emitting devices LED come into contact with both the first plurality of assembly wirings 121 and the plurality of second assembly wirings 122 during the manufacturing process of the display device 100.

FIG. 4 is a cross-sectional view of a modified example of FIG. 3. The display device 101 of FIG. 4 may adopt the features of the embodiments of FIGS. 1 to 3, and will be described focusing on the reflection layer 160.

Since the assembly wiring 120 according to the embodiment is disposed on the inclined surface of the second planarization layer 117, it serves as a side reflector and has a technical effect of improving light extraction efficiency to the front of the display device 100. In the display device 101 of FIG. 4, a reflection layer 160 may be additionally disposed on the assembly wiring 120 to increase light extraction efficiency.

The reflection layer 160 covers the second portion and third portion of the first assembly wiring 121, and the second portion and third portion of the second assembly wiring 122 and may be disposed below the third passivation layer 116. Since the reflection layer 160 is not disposed on the first portion of the second assembly wiring 122, the bonding force between the light emitting device 130 and the second assembly wiring 122 may not be reduced.

The reflection layer 160 may be made of a conductive material, for example, copper (Cu), aluminum (Al), molybdenum (Mo), nickel (Ni), titanium (Ti), chromium (Cr) or an alloy thereof, but is not limited thereto.

The reflection layer 160 may be formed together with the assembly wiring 120 using a halftone mask when forming the assembly wiring 120.

The display device 101 according to the embodiment has the technical effect of increasing the light extraction efficiency of the display device 101 by including assembly wiring 120 and a reflection layer 160.

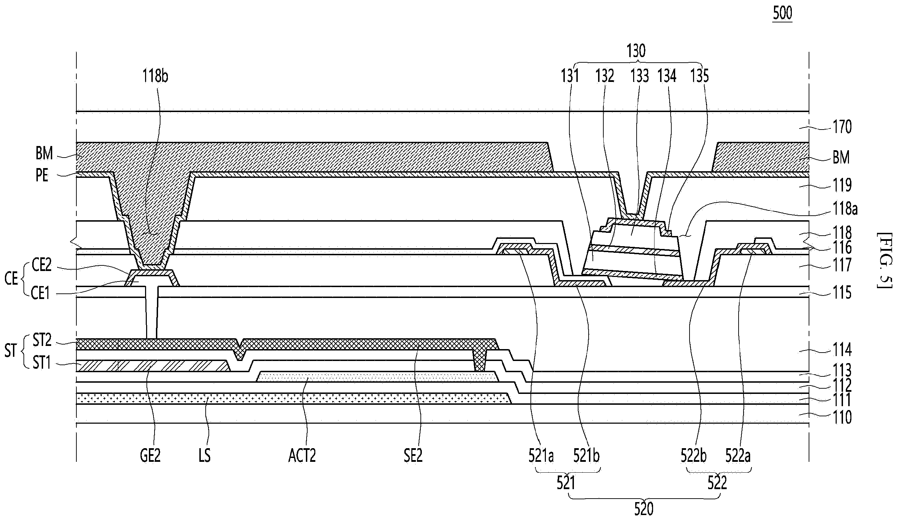

FIG. 5 is a cross-sectional view of a display device according to the second embodiment. The display device 500 of FIG. 5 has different assembly wiring 520 compared to the first embodiment, and the description will focus on this.

Referring to FIG. 5, the first conductive layer 521a of the plurality of first assembly wirings 521 and the second conductive layer 522a of the plurality of second assembly wirings 522 are disposed on the upper surface of the second planarization layer 117 and may be separated from the first opening.

The first clad layer 521b of the plurality of first assembly wirings 521 may be arranged to surround the first conductive layer 521a. And instead of the first conductive layer 521a that does not overlap the first opening, the first clad layer 521b extends toward the first opening, forming an electric field for self-assembly of a plurality of light emitting devices LED.

A portion of the first clad layer 521b may overlap the second planarization layer 117 and cover the top and side surfaces of the first conductive layer 521a. And the remaining portion of the first clad layer 521b extends inside the inclined surface of the second planarization layer 117 and the first opening to overlap a plurality of light emitting devices LED. However, since the third passivation layer 116 is disposed on the first clad layer 521b, the first clad layer 521b does not contact the first electrode 134 of the plurality of light emitting devices LED.

Like the first clad layer 521b, the second clad layer 522b of the plurality of second assembly wirings 522 may be arranged to surround the second conductive layer 522a. And instead of the second conductive layer 522a, which does not overlap the first opening, the second clad layer 522b extends toward the first opening, creating an electric field for self-assembly of a plurality of light emitting devices LED together with the first clad layer 521b.

A portion of the second clad layer 522b may overlap the second planarization layer 117 and cover the top and side surfaces of the second conductive layer 522a. And the remaining portion of the second clad layer 522b extends inside the inclined surface of the second planarization layer 117 and the first opening to overlap a plurality of light emitting devices LED. At this time, the third passivation layer 116 covers only a portion of the second clad layer 522b, so the second clad layer 522b and the first electrode 134 of the plurality of light emitting devices LED may contact each other, and a low-potential power supply voltage from the second assembly wiring 522 may be supplied to a plurality of light emitting devices LED.

In the display device 500 according to the second embodiment, since only the plurality of clad layers, that is, the first clad layer 521b and the second clad layer 522b, extend and are exposed inside the first opening, corrosion and short circuit defects of the first conductive layer 521a and the second conductive layer 522a may be reduced. The plurality of first assembly wirings 521 are composed of a first conductive layer 521a and a first clad layer 521b that is more resistant to corrosion than the first conductive layer 521a, and the plurality of second assembly wirings 522 are composed of a second conductive layer 522a and a second clad layer 522b that is more resistant to corrosion than the second conductive layer 522a. At this time, by forming the first clad layer 521b, second clad layer 522b, third passivation layer (116), and third planarization layer 118 to cover the first conductive layer 521a and second conductive layer 522a, which are relatively weak to corrosion, the first conductive layer 521a and the second conductive layer 522a may be prevented from being exposed to the fluid WT. In addition, after self-assembly is completed, the second assembly wiring 522 and the light emitting device LED may be electrically connected by bonding the first electrode 134 of the light emitting device LED on the second clad layer 522b extending inside the first opening. Therefore, in the display device 500 according to the second embodiment, there is a technical effect of reducing corrosion and short circuit defects of the plurality of assembly wirings 520 by arranging only the first clad layer 521b and the second clad layer 522b of each assembly wiring 520 at the first opening.

In the display device 500 according to the second embodiment, the bonding process of multiple light emitting devices LED may be easily performed with a low step difference between the first clad layer 521b and the second clad layer 522b at the first opening. Specifically, only the first clad layer 521b and the second clad layer 522b among the plurality of assembly wirings 520 may be disposed within the first opening where the plurality of light emitting devices LED are seated. At this time, the first clad layer 521b and the second clad layer 522b have a thinner thickness than the first conductive layer 521a and the second conductive layer 522a. Accordingly, the step difference may be reduced when only the first clad layer 521a and second clad layer 522b are placed compared to the case where the both first conductive layer521a and first clad layer521b and second conductive layer522a and second clad layer522b are placed in the first opening.

Therefore, when a plurality of light emitting devices LED are located within the first opening, the gap between a plurality of light emitting devices LED and the first clad layer 521b, that is, it is possible to minimize cases where a plurality of light emitting devices LED are placed in an unstable state floating in empty space on the first clad layer 521b, and a plurality of light emitting devices LED may be stably bonded on the second clad layer 522b.

Therefore, in the display device 500 according to the second embodiment, there is a technical effect in that a plurality of light emitting devices LED may be stably bonded to the second assembly wiring 522 by reducing the step between the plurality of assembly wirings 520 that overlap within the first opening.

In the display device 500 according to the second embodiment, there is a technical effect of improving the light extraction efficiency of the light emitting device 130 by arranging the first clad layer 521b and the second clad layer 522b to cover the slope of the second planarization layer 117 within the first opening.

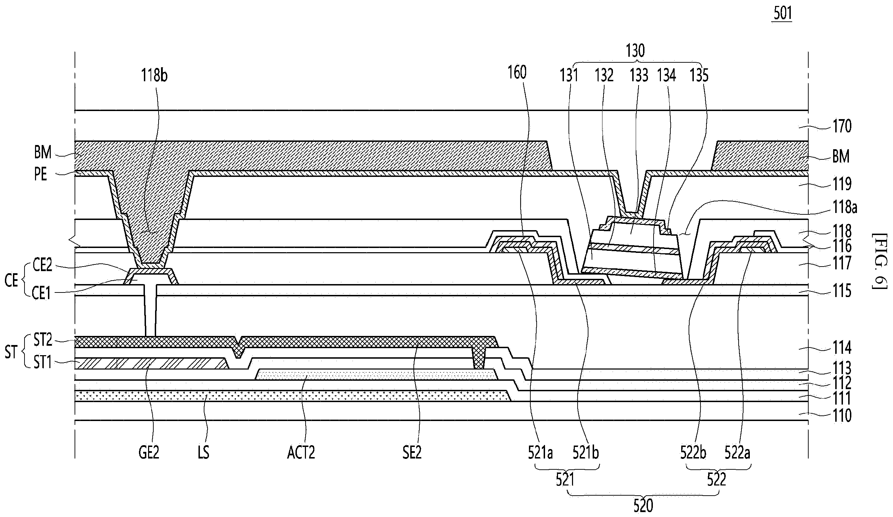

FIG. 6 is a cross-sectional view of a display device according to the third embodiment, and is a modified example of FIG. 5. The display device 501 of FIG. 6 has a different reflection layer 160 compared to the display device 500 of FIG. 5, and will be described focusing on this.

Since the assembly wiring 520 according to the third embodiment is disposed on the inclined surface of the second planarization layer 117, it serves as a side reflector, and thus has a technical effect of improving light extraction efficiency to the front of the display device (501). In the display device 501 of FIG. 5, a reflection layer 160 may be additionally disposed on the assembly wiring 520 to increase light extraction efficiency.

If the first assembly wiring 521 is divided into three portions, the first portion of the first assembly wiring 521 is disposed on the second passivation layer 115 inside the first opening, the second portion of the first assembly wiring 521 is disposed on the inclined surface (side) of the second planarization layer 117, and the third portion of the first assembly wiring 521 may be disposed on the upper surface of the third planarization layer 117. The second assembly wiring 522 is the same as the first assembly wiring 521, the first portion of the second assembly wiring 522 is disposed on the second passivation layer 115 inside the first opening, the second portion of the second assembly wiring 522 is disposed on the inclined surface (side) of the second planarization layer 117, and the third portion of the second assembly wiring 522 may be disposed on the upper surface of the third planarization layer 117.

The reflection layer 160 may cover the second portion and third portion of the first assembly wiring 521 and the second portion and third portion of the second assembly wiring 522, and the reflection layer 160 may be disposed below the third passivation layer 116. Since the reflection layer 160 is not disposed on the first portion of the second assembly wiring 522, the bonding force between the light emitting device 130 and the second assembly wiring 522 may not be reduced.

The reflection layer 160 may be made of a conductive material, for example, copper (Cu), aluminum (Al), molybdenum (Mo), nickel (Ni), titanium (Ti), chromium (Cr), or an alloy thereof, but is not limited thereto.

The reflection layer 160 may be formed together with the assembly wiring 520 using a halftone mask when forming the first clad layer 521b and the second clad layer 522b.

The display device 501 according to the third embodiment has the technical effect of increasing the light extraction efficiency of the display device 501 by including assembly wiring 520 and a reflection layer 160.

FIGS. 7A to 7C are process charts for explaining the manufacturing method of the display device according to the first embodiment, so these are process charts to explain the process of self-assembling a plurality of light emitting devices LED into the second opening 118a. The manufacturing method of the display device may also be applied to the second and third embodiments.

Referring to FIG. 7A, a light emitting device LED is introduced into the chamber CB filled with the fluid WT. The fluid WT may include water, etc., and the chamber CB filled with the fluid WT may have an open top.

Next, the mother substrate 10 may be placed on the chamber CB filled with a light emitting device LED. The mother substrate 10 is a substrate composed of a plurality of substrates 110 forming the display device 100, so, when self-assembling a plurality of light emitting devices LED, the mother substrate 10 formed with a plurality of assembly wirings 120 and a third planarization layer 118 may be used.

And the mother substrate 10 formed with the first assembly wiring 121, the second assembly wiring 122, and the third planarization layer 118 is placed on the chamber CB, or put it into the chamber CB. In this case, the mother substrate 10 may be positioned so that the second opening 118a of the third planarization layer 118 and the fluid WT face each other.

Then, the magnet MG may be placed on the mother substrate 10. Light emitting devices LED that sink or float on the bottom of the chamber CB may move toward the mother substrate 10 by the magnetic force of the magnet MG.

In this case, the light emitting device LED may include a magnetic material to move by a magnetic field. For example, the first electrode 134 or the second electrode 135 of a light emitting device LED may include a ferromagnetic material such as iron, cobalt, or nickel.

Next, referring to FIG. 7B and 7C, the light emitting device LED moved to the third planarization layer 118 by the magnet MG may be self-assembled in the second opening 118a by the electric field formed by the first assembly wiring 121 and the second assembly wiring 122.

An alternating voltage may be applied to the plurality of first assembly wirings 121 and the plurality of second assembly wirings 122 to form an electric field. Due to this electric field, a light emitting device LED may be dielectrically polarized and have polarity. And a dielectrically polarized light emitting device LED may be moved or fixed in a specific direction by dielectrophoresis (DEP), that is, an electric field. Therefore, a plurality of light emitting devices LED may be fixed within the second opening 118a of the third planarization layer 118 using dielectrophoresis.

At this time, the same voltage is applied to the plurality of first assembly wirings 121 and the plurality of second assembly wirings 122 when driving the display device 100, but different voltages are applied when manufacturing the display device 100. To this end, when manufacturing the display device 100, the plurality of first assembly wirings 121 and the plurality of second assembly wirings 122 may be connected to different assembly pads and different voltages may be applied.

In this regard, referring to FIG. 7C, when manufacturing the display device 100 or self-assembling the plurality of light emitting devices 130, the plurality of assembly wirings 120 may be connected to the assembly pad. Specifically, a plurality of substrates 110 forming the display device 100, a plurality of assembly pads, and a plurality of assembly wiring 120 connection parts may be disposed on the mother substrate 10.

The plurality of assembly pads are pads for applying voltage to a plurality of assembly wirings, and are electrically connected to a plurality of assembly wirings disposed on each of the plurality of substrates 110 forming the mother substrate 10. The plurality of assembly pads may be formed on the mother substrate 10 outside the substrate 110 of the display device 100, when the manufacturing process of the display device 100 is completed, it may be separated from the substrate 110 of the display device 100. For example, voltage is applied to the plurality of first assembly wirings 121 through the first assembly pad PD1, and a voltage may be applied to the plurality of second assembly wirings 122 through the second assembly pad PD2 to form an electric field for aligning the plurality of light emitting devices 130.

At this time, a plurality of first assembly wirings 121 arranged on one substrate 110 are connected together using a link line LL, and the plurality of second assembly wirings 122 may also be connected into one, so that each of the plurality of first assembly wirings 121 and the plurality of second assembly wirings 122 may be easily connected to the assembly pad.

For example, the plurality of first assembly wirings 121 may be connected to one through the link line LL, and the plurality of second assembly wirings 122 may also be connected to one through the link line LL. In this case, each of the plurality of first assembly wirings 121 and the plurality of second assembly wirings 122 disposed on one substrate 110 are not individually connected to the assembly pad, by electrically connecting the assembly pad and the link line LL connecting each of the plurality of first assembly wirings 121 and the plurality of second assembly wirings 122 into one, the voltage for self-assembly of the light emitting device 130 may be easily applied to the plurality of first assembly wirings 121 and the plurality of second assembly wirings 122.

Therefore, after placing the mother substrate 10 in the chamber CB into which the plurality of light emitting devices 130 are inserted, an electric field may be formed by applying alternating voltage to a plurality of assembly wirings 120 through a plurality of assembly pads, and a plurality of light emitting devices 130 may be easily self-assembled into the second opening 118a of the third planarization layer 118.

Next, mother substrate 10 may be flipped 180 degrees while a plurality of light emitting devices LED are fixed within the second opening118a using the electric fields of the plurality of first assembly wirings121 and the plurality of second assembly wirings122. If the mother substrate 10 is turned over without applying voltage to the plurality of first assembly wirings 121 and the plurality of second assembly wirings 122, the plurality of light emitting devices LED may escape within the second opening 118a. Therefore, with voltage applied to the plurality of first assembly wirings 121 and the plurality of second assembly wirings 122, the mother substrate 10 may be turned over and a subsequent process may be performed.

And in a state where the first electrode 134 of a plurality of light emitting devices LED is located on the plurality of second assembly wirings 122, the plurality of light emitting devices LED may be bonded to the plurality of second assembly wirings 122 by applying heat and pressure to the plurality of light emitting devices LED. For example, the first electrode 134 of a light emitting device LED may be bonded to the second assembly wiring 122 through eutectic bonding. Eutectic bonding is a bonding method using heat compression at high temperatures and is one of the bonding processes that is very strong and highly reliable. The eutectic bonding method not only realizes high bonding strength, but also has the advantage of eliminating the need to apply a separate adhesive from the outside. However, the bonding method of a plurality of light emitting devices LED may be configured in various ways other than eutectic bonding, but is not limited thereto.

After the self-assembly process of a plurality of light emitting devices LED is completed, the mother substrate 10 may be cut along the scribing line and separated into a plurality of substrates 110. Thereafter, the same voltage may be easily applied to the plurality of first assembly wirings 121 and the plurality of second assembly wirings 122 through a link line LL connecting a plurality of first assembly wirings 121 into one and a link line LL connecting a plurality of second assembly wirings 122 into one.

For example, when driving display device 100, by connecting the link line LL connecting each of the plurality of first assembly wirings 121 and the plurality of second assembly wirings 122 into one and the driving IC, a voltage may be applied to the plurality of first assembly wirings 121 and the plurality of second assembly wirings 122.

On the other hand, when self-assembling a plurality of light emitting devices LED for each sub-pixel SP, a plurality of assembly wirings 120 arranged in a plurality of red sub-pixels SPR, a plurality of assembly wiring 120 arranged in a plurality of green sub-pixels SPG and a plurality of assembly wirings 120 arranged in a plurality of blue sub-pixels SPB may be connected to different assembly pads. A light emitting device LED may be selectively self-assembled only in a specific sub-pixel SP among the plurality of sub-pixels SP through a plurality of assembly pads. The self-assembled mother substrate 10 may be separated into a plurality of substrates 110 by scribing. Thereafter, the same voltage may be easily applied to the plurality of first assembly wirings 121 and the plurality of second assembly wirings 122 through the link line connecting the plurality of first assembly wirings 121 into one and the link wiring connecting the plurality of second assembly wirings 122 into one.

In the display device 100 according to the embodiment, at least some of the assembly wiring 120 for self-assembly of a plurality of light emitting devices LED may be used as wiring for applying a low-potential power supply voltage to the plurality of light emitting devices LED. When manufacturing the display device 100, a plurality of light emitting devices LED floating in the fluid WT may be moved adjacent to the mother substrate 10 using a magnetic field. Next, different voltages may be applied to the plurality of first assembly wirings 121 and the plurality of second assembly wirings 122 to form an electric field, and a plurality of light emitting devices LED may be self-assembled within the plurality of second openings 118a by an electric field. In this case, instead of forming a separate wiring that supplies low-potential voltage and connecting it to a plurality of self-assembled light emitting devices LED, by bonding the first electrode 134 of the light emitting device LED to the second assembly wiring 122, a portion of which is exposed within the second opening 118a, when driving the display device 100, a plurality of assembly wirings 120 may be used as wiring to supply low-potential voltage to a plurality of light emitting devices LED. Therefore, in the display device 100 according to the embodiment, there is a technical effect in that the plurality of assembly wirings 120 may be used not only for self-assembly of a plurality of light emitting devices LED but also as wiring for driving a plurality of light emitting devices LED.

In the display device 100 according to the embodiment, since the plurality of assembly wirings 120 include a clad layer, there is a technical effect of reducing corrosion or short circuit defects in the plurality of assembly wirings 120. The plurality of first assembly wirings 121 surround the first conductive layer 121a and the first conductive layer 121a, and includes a first clad layer 121b that is more resistant to corrosion than the first conductive layer 121a, and the plurality of second assembly wirings 122 surround the second conductive layer 122a and the second conductive layer 122a, and may include a second clad layer 122b that is more resistant to corrosion than the second conductive layer 122a. When manufacturing the display device 100, a plurality of light emitting devices LED may be self-assembled by placing the mother substrate 10 on which a plurality of assembly wirings 120 are formed within the fluid WT. In this case, the first conductive layer 121a and/or the second conductive layer 122a may be exposed in the fluid WT and the assembly wiring 120 may be corroded, which may cause a short circuit defect. Therefore, the first conductive layer 121a of the plurality of first assembly wirings 121 may be covered with the first clad layer 121b, the third passivation layer (116), and the third planarization layer 118, and the second conductive layer 122a of the plurality of second assembly wirings 122 may be covered with the second clad layer 122b and the third planarization layer 118. Accordingly, the plurality of assembly wirings 120 are formed in a structure including a first clad layer 121b and a second clad layer 122b, which has the technical effect of improving the reliability of the plurality of assembly wirings 120.

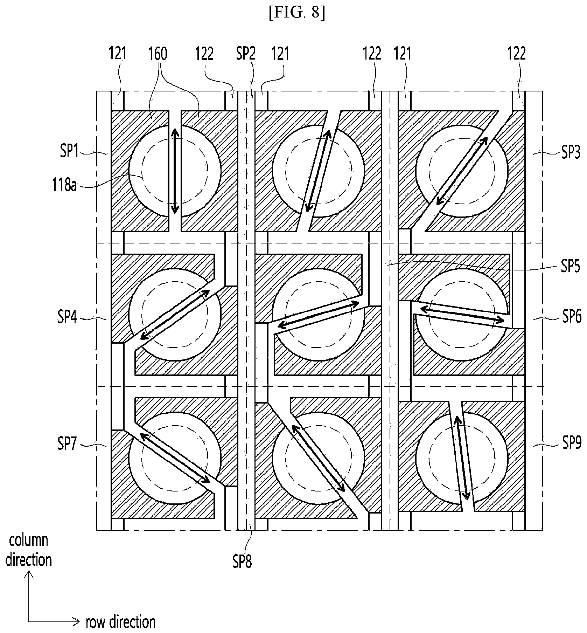

FIG. 8 is a plan view showing assembly wiring arranged isometrically in unit pixels included in a display device according to an embodiment. The arrangement of assembly wiring in FIG. 8 may be applied to all embodiments described above. For convenience of explanation, FIG. 8 shows only the assembly wiring 120, the reflection layer 160, and the third opening 118a of the third planarization layer.

In the display device 101 according to the embodiment, since the plurality of assembly wirings 120 are disposed on the inclined surface of the second planarization layer 117 surrounding a portion of the light emitting device, light extraction efficiency may be increased as described above, but viewing angle characteristics may be deteriorated. To solve this problem, the arrangement of the assembly wiring 120 for each unit pixel may be varied.

In the display device 101 according to the embodiment, an example will be given in which a unit pixel includes three sub-pixels arranged in a row direction and three sub-pixels arranged in a column direction. However, it is not limited to this.

The unit pixel may be determined in various ways, but may include at least two sub-pixels in the row direction and two sub-pixels in the column direction. The unit pixel may include a first sub-pixel SP1, a second sub-pixel SP2, a third sub-pixel SP3, a fourth sub-pixel SP4, a fifth sub-pixel SP5, a sixth sub-pixel SP6, a seventh sub-pixel SP7, an eighth sub-pixel SP8, a ninth sub-pixel SP9.

The first assembly wiring 121 and the second assembly wiring 122 may be each divided into a first wiring shared with sub-pixels arranged in the column direction and a second wiring protruding from the stripe wiring to each of the plurality of sub-pixels. FIG. 8 is an embodiment including the reflection layer 160 and is a top view, so the second wiring is obscured by the reflection layer 160 and is not visible in the drawing.

In the drawing, the second wiring shows the first wiring and the second wiring of the first assembly wiring 121 and the first wiring and the second wiring of the second assembly wiring 122 for each sub-pixel, but since the plurality of sub-pixels each include a red sub-pixel SPR, a green sub-pixel SPG, and a blue sub-pixel SPB, in practice, the first and second wirings of the first assembly wiring 121 and the first and second wirings of the second assembly wiring 122 may include three each.

The first assembly wiring 121 and the second assembly wiring 122 may be spaced apart from each other at a certain distance. The direction perpendicular to the direction of separation is called the arrangement direction of the assembly wiring and is indicated by an arrow in the drawing. In order to improve the viewing angle in a display device according to an embodiment, the arrangement direction of assembly wiring may be different for each sub-pixel within a unit pixel. Additionally, in order to ensure uniform characteristics at all viewing angles, the arrangement direction of assembly wiring between sub-pixels may be formed at equal intervals. Additionally, the arrangement direction of the assembly wiring of other sub-pixels surrounding one sub-pixel may be different from the arrangement direction of the assembly wiring of the sub-pixel in the center.

In a unit pixel including 9 sub-pixels, the arrangement direction of the assembly wiring of each sub-pixel SP1, SP2, SP3, SP4, SP5, SP6, SP7, SP8, SP9 may be arranged at intervals of 20°. The spacing in the arrangement direction of the assembly wiring of a plurality of sub-pixels may be calculated by dividing 180° by the number of sub-pixels included in the unit pixel.

Referring to FIG. 8, based on the column direction, the arrangement direction of the assembly wiring of the first sub-pixel SP1 may be set to 0° as the reference sub-pixel, the arrangement direction of the assembly wiring of the second sub-pixel SP2 may be 20°, the arrangement direction of the assembly wiring of the third sub-pixel SP3 may be 40°, the arrangement direction of the assembly wiring of the fourth sub-pixel SP4 may be 60°, the arrangement direction of the assembly wiring of the fifth sub-pixel SP5 may be 80°, the arrangement direction of the assembly wiring of the sixth sub-pixel SP6 may be 100°, the arrangement direction of the assembly wiring of the seventh sub-pixel SP7 may be 120°, the arrangement direction of the assembly wiring of the eighth sub-pixel SP8 may be 140°, and the arrangement direction of the assembly wiring of the ninth sub-pixel SP9 may be 160°.

In the display device according to the embodiment, there is a technical effect of securing the viewing angle characteristics of the display device by arranging the assembly wiring of the plurality of sub-pixels included in the unit pixel differently at equal intervals.

FiIG. 9 is a cross-sectional view of the display device 600 according to the fourth embodiment. The fourth embodiment may adopt the features of the first to third embodiments. For example, since the assembly wiring 620 according to the fourth embodiment is disposed on the inclined surface of the second planarization layer 117, it serves as a side reflector and has the technical effect of improving light extraction efficiency to the front of the display device 600. Hereinafter, the description will focus on the shape of the assembly wiring 620.

The assembly wiring 620 of the fourth embodiment may be disposed on the inclined surface of the second planarization layer 117 and the second planarization layer 117. In detail, part of the first clad layer 621b and the second clad layer 622b may be placed on the slope of the second planarization layer 117, and the first conductive layer 621a and the second conductive layer 622a may be placed on the second planarization layer 117. Additionally, a first clad layer 621b and a second clad layer 622b covering the first conductive layer 621a and the second conductive layer 622a, respectively, may also be disposed on the second planarization layer 117.

The first assembly wiring 621 and the second assembly wiring 621, which play the role of a side reflector, are arranged to correspond to the height of the light emitting device 130 assembled in the first opening 118a, so there is a technical effect that may further improve light extraction efficiency to the front of the display device 600. In addition, since the light generated from the light emitting device 130 is not emitted in an unintended direction, there is a technical effect of preventing color mixing and crosstalk phenomenon that mix with light from other light emitting devices.

In addition, a reflection layer 160 may be additionally disposed on one side of the first clad layer 621b and the second clad layer 622b disposed on the sides of the first conductive layer 621a and the second conductive layer 622a, respectively, on the inclined surface of the second planarization layer 117. In this case, there is a technical effect of further improving light extraction efficiency to the front of the display device by reflecting the light exiting the side of the light emitting device.

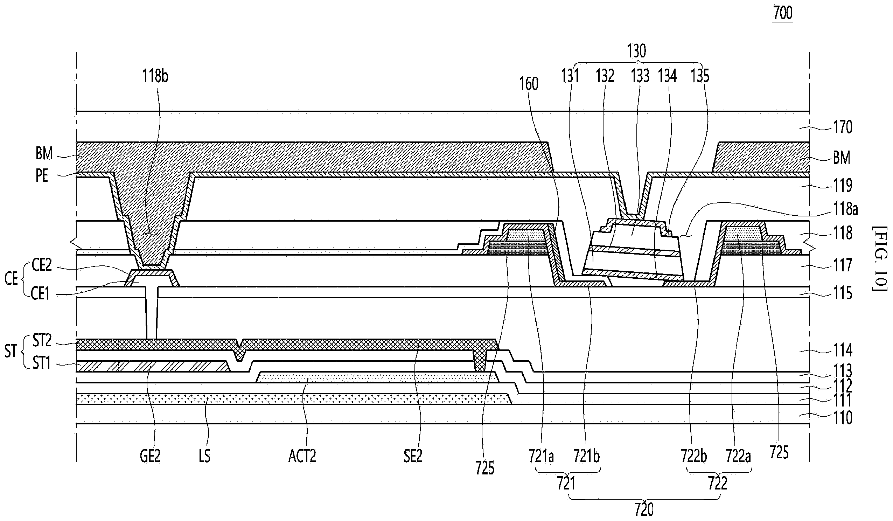

Next, FIG. 10 is a cross-sectional view of the display device 700 according to the fifth embodiment. The fifth embodiment may adopt the features of the first to fourth embodiments. For example, since the assembly wiring 720 according to the fifth embodiment is disposed on the inclined surface of the second planarization layer 117, it serves as a side reflector and has the technical effect of improving light extraction efficiency to the front of the display device 700. Hereinafter, the description will focus on the shape of the assembly wiring 720.

The assembly wiring 720 of the fifth embodiment may be disposed on the inclined surface of the second planarization layer 117 and the second planarization layer 117. In detail, portion of the first clad layer 721b and the second clad layer 722b may be placed on the slope of the second planarization layer 117, and the first conductive layer 721a and the second conductive layer 722b may be placed on the second planarization layer 117.

At this time, the first conductive layer 721a and the second conductive layer 722a may be disposed on the regular taper-shaped structure 725 disposed on the second planarization layer 117. In addition, a portion of the first clad layer 721b and the second clad layer 722b, which cover the first conductive layer 721a and the second conductive layer 722a, respectively, may be in contact with the top and side surfaces of the regular taper-shaped structure 725. Since the first assembly wiring 721 and the second assembly wiring 722 are each supported by the regular taper-shaped structure 725, there is a technical effect of improving the structural stability of the assembly wiring.

In addition, a reflection layer 160 may be additionally disposed on one side of the first clad layer 721b and the second clad layer 722b disposed on the sides of the first conductive layer 721a and the second conductive layer 722a, respectively, on the inclined surface of the second planarization layer 117. In this case, there is a technical effect of further improving light extraction efficiency to the front of the display device by reflecting the light exiting the side of the light emitting device.

The display device including the semiconductor light emitting device according to the above-described embodiment has the technical effect of preventing deterioration of the insulation properties of the passivation layer and improving the assembly rate of the light emitting device by arranging the assembly wiring on the same layer.

According to the embodiment, the technical effect of light extraction efficiency of the light emitting device may be improved by arranging the assembly wiring on the inclined surface of the planarization layer including the pocket where the light emitting device will be placed.

According to the embodiment, the technical effect of light extraction efficiency of the light emitting device may be improved by arranging the assembly wiring on the inclined surface of the planarization layer including the pocket where the light emitting device will be placed.

In addition, the embodiment has a technical effect in that a plurality of assembly wirings may be used not only for self-assembly of the light emitting device, but also as wiring for driving the light emitting device.

Additionally, the embodiment has the technical effect of preventing narrowing of the viewing angle by varying the arrangement of the assembly wiring for each unit pixel at an isometric angle.

In addition, the embodiment has the technical effect of improving the reliability of the assembly wiring by forming a plurality of assembly wiring structures including a clad layer.

For example, there is a technical effect of reducing corrosion and short circuit defects in multiple assembly wirings by placing only the first clad layer and second clad layer of each assembly wiring at the first opening.

The embodiment has the technical effect of reducing the step between a plurality of assembly wirings overlapping within an opening provided in the planarization layer, thereby stably bonding a plurality of light emitting devices to the assembly wiring.

The above detailed description should not be construed as restrictive in any respect and should be considered illustrative. The scope of the embodiments should be determined by reasonable interpretation of the appended claims, and all changes within the equivalent scope of the embodiments are included in the scope of the embodiments.

### [Explanation of signs]

10: Mother substrate AA: Display area NA: Non-display area SP: Sub-pixel
SPR: Red sub-pixel SPG: Green sub-pixel SPB: Blue sub-pixel
100, 101, 500, 501, 600, 700: Display device 110: Substrate
111: Buffer layer 112: Gate insulation layer 113: First passivation layer 114: First planarization layer
115: Second passivation layer 116: Third passivation layer 117: Second planarization layer
118: Third planarization layer 118a: Second opening 118b: Third opening 119: Fourth planarization layer
160: Reflection layer 170: Protective layer 120, 520, 620, 720: Assembly wiring
121, 521, 621, 721: First assembly wiring 121a, 521a, 621a, 721a: First conductive layer
121b, 521b, 621b, 721b: First clad layer 122, 522, 622, 722: Second assembly wiring
122a, 522a, 622a, 722a: Second conductive layer 122b, 522b, 622b, 722b: Second clad layer
130, LED: Light emitting device 131: First semiconductor layer 132: Light emitting layer
133: Second semiconductor layer 134: First electrode 135: Second electrode 140: green light emitting device
150: Blue light emitting device 725: Structure LS: Light blocking layer SL: Scan line
DL: Data line RL: Reference line VDD: High potential power line
VDD1: First layer VDD2: second layer VDD3: Third layer TR1: first transistor
ACT1: First active layer GE1: First gate electrode SE1: First source electrode
DE1: First drain electrode TR2: Second transistor ACT2: Second active layer
GE2: Second gate electrode SE2: Second source electrode DE2: Second drain electrode
TR3: Third transistor ACT3: Third active layer GE3: Third gate electrode
SE3: Third source electrode DE3: Third drain electrode SA: Step area
ST: Storage capacitor ST1: First capacitor electrode ST2: Second capacitor electrode
CE: Connection electrode CE1: First connection layer CE2: Second connection layer PE: Pixel electrode
BM: Black Matrix CB: Chamber WT: Fluid MG: Magnet

### [Industrial Applicability]

The embodiment may be adopted in the field of displays that display images or information.

The embodiment may be adopted in the field of displays that display images or information using semiconductor light-emitting devices.

The embodiment may be adopted in the field of displays that display images or information using micro- or nano-level semiconductor light-emitting devices.

## Claims

1. The display device having a semiconductor light emitting device, comprising:
a substrate;
a first planarization layer comprising a first opening on the substrate;
a first assembly wiring and a second assembly wiring arranged to be spaced apart from each other inside the first opening and on the first planarization layer;
a second planarization layer covering a portion of the first assembly wiring and the second assembly wiring and comprising a second opening;
a light emitting device disposed inside the second opening, wherein a first electrode overlaps the first assembly wiring and the second assembly wiring; and
an insulation layer covering the first assembly wiring or the second assembly wiring disposed inside the first opening;
wherein the first electrode is bonded to one of the first assembly wiring or the second assembly wiring.

2. The display device having the semiconductor light emitting device according to claim 1, wherein the first assembly wiring comprises a first conductive layer and a first clad layer surrounding the first conductive layer, and
wherein the second assembly wiring comprises a second conductive layer and a second clad layer surrounding the second conductive layer.

3. The display device having the semiconductor light emitting device according to claim 2, wherein the first conductive layer and the second conductive layer are thicker than the first clad layer and the second clad layer.

4. The display device having the semiconductor light emitting device according to claim 2, wherein the first conductive layer and the second conductive layer are disposed only on the first planarization layer.

5. The display device having the semiconductor light emitting device according to claim 1, further comprising a reflection layer disposed on the first assembly wiring and the second assembly wiring.

6. The display device having the semiconductor light emitting device according to claim 1, wherein the first assembly wiring comprises a first portion disposed inside the first opening, a second portion disposed on an inclined surface of the first planarization layer, and a third portion disposed on an upper surface of the second planarization layer, and
wherein the second assembly wiring comprises a fourth portion disposed inside the first opening, a fifth portion disposed on the inclined surface of the first planarization layer, and a sixth portion disposed on the upper surface of the second planarization layer.

7. The display device having the semiconductor light emitting device according to claim 6, wherein the insulation layer is configured to cover the first portion, the second portion, and the third portion.

8. The display device having the semiconductor light emitting device according to claim 7, wherein the first electrode is in contact with the second assembly wiring.

9. The display device having the semiconductor light emitting device according to claim 6, wherein the second planarization layer is configured to cover the second portion, the third portion, the fifth portion, and the sixth portion.

10. The display device having the semiconductor light emitting device according to claim 1, wherein a sum of height of the first planarization layer and the second planarization layer is equal to or greater than a height of the light emitting device.

11. The display device having the semiconductor light emitting device according to claim 4, wherein a height of at least one of the first and second clad layers is equal to or greater than a height of the light emitting device.

12. The display device having the semiconductor light emitting device according to claim 11, further comprises a structure disposed on the first planarization layer, and
wherein the first and second conductive layers are disposed on the structure.

13. The display device having the semiconductor light emitting device according to claim 12, wherein the first and second clad layers are in contact with the first and second conductive layers and the structure, respectively, and
further comprises a reflection layer disposed on at least one surface of the first and second clad layers.

14. A display device having a semiconductor light emitting layer, comprising
a substrate comprising a plurality of pixels comprising a plurality of sub-pixels, and unit pixels comprising the plurality of pixels;
a planarization layer comprising at least one opening in each of the plurality of sub-pixels;
a plurality of first assembly wirings and a plurality of second assembly wirings arranged to be spaced apart from each other inside the opening and on the planarization layer; and
a plurality of light emitting devices disposed inside the opening, the first electrode of which overlaps the plurality of first assembly wirings and the plurality of second assembly wirings,
wherein within the unit pixel, the plurality of first assembly wirings and the plurality of second assembly wirings comprised in each of the plurality of pixels are spaced apart and arranged in different directions.

15. The display device having the semiconductor light emitting device according to claim 11, wherein the first electrode is bonded to one of the first assembly wiring or the second assembly wiring.

16. The display device having the semiconductor light emitting device according to claim 11, further comprising an insulation layer covering any one of the first assembly wiring or the second assembly wiring.

17. The display device having the semiconductor light emitting device according to claim 11, further comprising a reflection layer disposed outside the opening on the first assembly wiring and the second assembly wiring.

18. The display device having the semiconductor light emitting device according to claim 11, wherein the plurality of first assembly wirings and the plurality of second assembly wirings are each arranged to extend to the plurality of sub-pixels arranged in a column direction.

19. The display device having the semiconductor light emitting device according to claim 11, wherein in the plurality of sub-pixels comprised in each of the plurality of pixels, the plurality of first assembly wirings and the plurality of second assembly wirings are spaced apart and arranged in the same direction.

20. The display device having the semiconductor light emitting device according to claim 11, wherein directions in which the plurality of first assembly wirings and the plurality of second assembly wirings comprised in each of the plurality of pixels within the unit pixel are spaced apart and arranged have a same angle difference.
